# EUROPÄISCHE PATENTSCHRIFT

(11) **EP 4 046 228 B1**
(45) Veröffentlichungstag und Bekanntmachung des Hinweises auf die Patenterteilung: **06.12.2023**
(21) Anmeldenummer: 20788753.0
(22) Anmeldetag: 07.10.2020
(51) Int. Cl.: H01M 10/44, H01M 10/42, H01M 10/48

(54) **VERFAHREN ZUM ANPASSEN EINER ANODENÜBERSPANNUNG EINER LITHIUM-IONEN-BATTERIE, VERFAHREN ZUM VERBESSERN EINES KAPAZITÄTSALTERUNGSZUSTANDS DER LITHIUM-IONEN-BATTERIE**
METHOD OF ADAPTING AN ANODE OVERVOLTAGE OF A LITHIUM-ION BATTERY AND METHOD OF IMPROVING A STATE OF HEALTH (SOH) OF THE LITHIUM-ION BATTERY
MÉTHODE D'ADAPTER UNE SURTENSION ANODIQUE D'UNE BATTERIE LI-ION ET MÉTHODE D'IMPROUVER L'ÉTAT DE SANTÉ DE LA BATTERIE LI-ION

(30) Priorität: 17.10.2019 DE 102019216015
(43) Veröffentlichungstag der Anmeldung: 24.08.2022
(73) Patentinhaber: Robert Bosch GmbH, 70442 Stuttgart (DE)
(72) Erfinder: KROENER, Christoph, 90574 Rosstal (DE)
(86) Internationale Anmeldenummer: PCT/EP2020/078067
(87) Internationale Veröffentlichungsnummer: WO 2021/073964

(56) Entgegenhaltungen:
- EP-A2- 3 197 006
- WO-A1-2016/100919
- US-A1- 2011 316 548

## Beschreibung

Die Erfindung betrifft ein Verfahren zum Anpassen einer Anodenüberspannung einer Lithium-Ionen-Batterie.

Die Erfindung betrifft ferner ein Verfahren zum Verbessern eines Kapazitätsalterungszustands einer Lithium-Ionen-Batterie.

Die Erfindung betrifft auch ein Fahrzeug mit mindestens einer Lithium-Ionen-Batterie, deren Anodenüberspannung gemäß dem Verfahren zum Anpassen der Anodenüberspannung der Lithium-Ionen-Batterie angepasst ist und/oder deren Kapazitätsalterungszustand gemäß dem Verfahren zum des Kapazitätsalterungszustands der Lithium-Ionen-Batterie verbessert ist.

Die Erfindung betrifft auch ein Flottenmanagementsystem, das eingerichtet ist, das Verfahren zum Anpassen der Anodenüberspannung der Lithium-Ionen-Batterie und/oder das Verfahren zum des Kapazitätsalterungszustands der Lithium-Ionen-Batterie durch zuführen.

### Stand der Technik

Lithium-Ionen-Batterien gelten als Energiespeicher der Zukunft. Sie können viel Strom auf wenig Raum bei vergleichsweise geringem Gewicht speichern. Allerdings haben Lithium-Ionen-Batterien das Problem des Lithium-Plating, bei dem sich beim Laden der Lithium-lonen-Batterien metallisches Lithium bildet und ablagert und so die Lebensdauer der Lithium-Ionen-Batterien verringert oder sogar ein Kurzschluss oder Brand verursachen kann.

Zum Abschätzen eines Kapazitätsalterungszustands (SOHC, engl.: Capacity State of Health) der Lithium-Ionen-Batterie, wird eine Anodenüberspannung der Lithium-Ionen-Batterie verwendet. Es wird angenommen, dass der Kapazitätsalterungszustand der Lithium-Ionen-Batterie normal ist, sofern das Anodenüberspannung weit oberhalb 0 mV liegt, und der Kapazitätsalterungszustand der Lithium-lonen-Batterie verschlechtert wird, d.h., die Alterung der Lithium-lonen-Batterie wird durch das erhöhte Lithium-Plating beschleunigt, sobald die Anodenüberspannung an die 0 mV kommt.

Das Dokument US 2014/0312912 A1 offenbart ein Verfahren und Schaltungen zum adaptiven Laden einer Batterie.

Aus dem Dokument US 2006/0238168 A1 ist ein Verfahren zum Erfassen von Batterieeigenschaften bekannt.

### Offenbarung der Erfindung

Es wird ein Verfahren zum Anpassen eines Grenzwerts einer Anodenüberspannung einer Lithium-lonen-Batterie vorgeschlagen.

Zunächst werden Signalverläufe der Lithium-lonen-Batterie bereitgestellt. Die Signalverläufe umfassen zumindest Spannungs-, Stroms- und Betriebstemperaturverläufe sowie eines Kapazitätsalterungszustandsverlaufs der Lithium-lonen-Batterie. Dabei wird ein Kapazitätsverlust der Lithium-lonen-Batterie durch den Kapazitätsalterungszustandsverlauf dargestellt.

Die Signalverläufe und der Kapazitätsalterungszustandsverlauf der Lithium-ionen-Batterie werden anschließend zu einer Speichereinrichtung übertragen. Dabei sind in der Speichereinrichtung Daten von mehreren Lithium-lonen-Batterien gespeichert, wobei die Daten zumindest Spannungs-, Stroms- und Betriebstemperaturverläufe sowie einen Kapazitätsalterungszustandsverlauf und einen Grenzwert der Anodenüberspannung der jeweiligen Lithium-lonen-Batterie umfassen.

Danach werden die Signalverläufe der Lithium-lonen-Batterie mit den in der Speichereinrichtung gespeicherten Daten verglichen und Vergleichsbatterien, deren Signalverläufe ähnlich wie die Signalverläufe der Lithium-lonen-Batterie sind, werden ausgesucht. Die Ähnlichkeit zwischen den Signalverläufen kann dabei mittels einer Methode der kleinsten Quadrate (engl.: Least Squares) definiert werden. Die Lithium-lonen-Batterien werden bevorzugt über ähnliche Zeitintervalle verglichen.

Anschließend werden die Daten der Vergleichsbatterien zum Erhalten eines durchschnittlichen Kapazitätsalterungszustandsverlaufs sowie eines durchschnittlichen Kapazitätsverlusts der Vergleichsbatterien untersucht. Dabei wird ebenfalls ein dem durchschnittlichen Kapazitätsverlust entsprechender optimierter Grenzwert der Anodenüberspannung erhalten.

Danach wird der Kapazitätsalterungszustandsverlauf der Lithium-lonen-Batterie mit dem durchschnittlichen Kapazitätsalterungszustandsverlauf der Vergleichsbatterien verglichen.

Anschließend wird der Grenzwert der Anodenüberspannung der Lithium-lonen-Batterie an den optimierten Grenzwert der Anodenüberspannung angepasst, wenn erkannt wird, dass der Kapazitätsalterungszustandsverlauf der Lithiumbatterie unter dem durchschnittlichen Kapazitätsalterungszustandsverlauf der Vergleichsbatterien liegt. Mit dem an den optimierten Grenzwert angepassten Grenzwert der Anodenüberspannung der Lithium-lonen-Batterie stimmt der Kapazitätsverlust der Lithium-lonen-Batterie mit dem durchschnittlichen Kapazitätsverlust überein.

Bevorzugt werden die Signalverläufe und der Kapazitätsalterungszustandsverlauf der Lithium-lonen-Batterie mittels eines drahtlosen Netzwerks zu der Speichereinrichtung übertragen.

Dabei kann das drahtlose Netzwerk als ein WLAN-Netzwerk ausgebildet werden. Vorzugsweise wird das drahtlose Netzwerk als ein Mobilfunknetz, wie beispielsweise ein UMTS- oder LTE-Netz, ausgebildet.

Bevorzugt wird die Speichereinrichtung als ein Cloud-Speicher ausgebildet werden. Denkbar ist aber auch, dass die Speichereinrichtung ein Speichermedium, wie beispielsweise ein Speicher eines Steuergeräts der Lithium-lonen-Batterie oder ein externer Speicher, ausgebildet wird.

Vorzugsweise weist die Speichereinrichtung ein auf künstliche Intelligenz basiertes Modell zum Anpassen des Grenzwerts der Anodenüberspannung der Lithium-lonen-Batterie auf. Mittels des auf künstliche Intelligenz basierten Modells werden Vergleichsbatterien anhand der Spannungs-, der Stroms- sowie der Betriebstemperaturverläufe der Lithium-lonen-Batterie in den in der Speichereinrichtung gespeicherten Daten ausgesucht. Mittels des auf künstliche Intelligenz basierten Modells werden die Daten der Vergleichsbatterien untersucht, um einen durchschnittlichen Kapazitätsalterungszustandsverlauf und einen durchschnittlichen Kapazitätsverlust der Vergleichsbatterien sowie einen dem durchschnittlichen Kapazitätsverlust entsprechenden optimierten Grenzwert der Anodenüberspannung zu erhalten. Durch Vergleich kann das auf künstliche Intelligenz basierte Modell erkennen, dass der Kapazitätsalterungszustandsverlaufs der Lithium-lonen-Batterie unter der durchschnittlichen Kapazitätsalterungszustandsverlauf liegt und den optimierten Grenzwert der Anodenüberspannung liefern. Der Grenzwert der Anodenüberspannung der Lithium-lonen-Batterie wird dann an den optimierten Grenzwert angepasst.

Es wird ferner ein Verfahren zum Verbessern eines Kapazitätsalterungszustands einer Lithium-lonen-Batterie vorgeschlagen.

Dabei wird zunächst ein Kapazitätsalterungszustand der Lithium-lonen-Batterie mittels eines Batteriemodells berechnet. Dabei wird ein Grenzwert einer Anodenüberspannung der Lithium-lonen-Batterie abgeschätzt. Das Batteriemodell kann selbstverständlich weitere Parameter der Lithium-lonen-Batterie berechnen, wie beispielsweise einen Ladezustand und eine Lithium-Ionen-Konzentration.

Anschließend wird ein optimaler Ladestrom für die Lithium-lonen-Batterie mittels eines Lademodells derart berechnet, dass die Anodenüberspannung der Lithium-ionen-Batterie den Grenzwert nicht unterschreitet, d.h. die Anodenüberspannung der Lithium-lonen-Batterie soll größer als oder zumindest gleich dem Grenzwert sein.

Danach wird die Lithium-lonen-Batterie mit dem optimalen Ladestrom geladen und überwacht. Dabei werden ein Kapazitätsalterungszustandsverlauf sowie Signalverläufe der Lithium-lonen-Batterie erfasst, die zumindest Spannungs-, Stroms- und Betriebstemperaturverläufe umfassen.

Anschließend wird der Grenzwert der Anodenüberspannung der Lithium-lonen-Batterie mittels des erfindungsgemäßen Verfahrens zum Anpassen eines Grenzwerts einer Anodenüberspannung einer Lithium-lonen-Batterien angepasst.

Danach wird der optimale Ladestrom mittels des Lademodells mit dem angepassten Grenzwert der Lithium-lonen-Batterie erneut berechnet.

Bevorzugt wird die Lithium-lonen-Batterie mit einem Batteriemanagementsystem zum Überwachen und Steuern der Lithium-lonen-Batterie sowie zum Erfassen eines Kapazitätsalterungszustandsverlaufs und der Signalverläufe der Lithium-ionen-Batterie versehen. Bevorzugt wird das Batteriemodell im Batteriemanagementsystem integriert.

Vorzugsweise wird der optimale Ladestrom basierend auf eine Optimalsteuerungstheorie berechnet. Bevorzugt wird das Lademodell ebenfalls im Batteriemanagementsystem integriert. Dabei kann der durch das Batteriemodell abgeschätzte Grenzwert der Anodenüberspannung direkt zu dem Lademodell übermittelt. Es ist ebenfalls möglich, dass der Grenzwert über das Batteriemanagementsystem eingestellt wird.

Vorzugsweise wird das Batteriemanagementsystem mit einer telematischen Steuereinheit zur Datenübertragung zwischen dem Batteriemanagementsystem und der Speichereinrichtung versehen.

Das Batteriemanagementsystem kann auch einen Speicher zum Speichern von Daten der Lithium-lonen-Batterie aufweisen. Zu den Daten der Lithium-lonen-Batterie gehören z.B. die Anodenüberspannung und weitere elektrochemische Parameter der Lithium-lonen-Batterie, die in einem Labor vermessen werden.

Es wird auch ein Fahrzeug mit mindestens einer Lithium-lonen-Batterie vorgeschlagen, deren Anodenüberspannung nach dem erfindungsgemäßen Verfahren zum Anpassen einer Anodenüberspannung einer Lithium-lonen-Batterie angepasst ist und/oder deren Kapazitätsalterungszustand nach dem erfindungsgemäßen Verfahren zum Verbessern eines Kapazitätsalterungszustands einer Lithium-lonen-Batterie verbessert ist.

Weitere Informationen oder Parameter des Fahrzeugs, wie z.B. ein Nutzungsprofil des Fahrzeugs und Fahrstil eines Fahrers, können dabei ebenfalls zu der Speichereinrichtung übertragen werden.

Ferner wird ein Flottenmanagementsystem vorgeschlagen, das eingerichtet ist, das erfindungsgemäße Verfahren zum Anpassen einer Anodenüberspannung einer Lithium-lonen-Batterie und/oder das erfindungsgemäße Verfahren zum Verbessern eines Kapazitätsalterungszustands einer Lithium-lonen-Batterie durchzuführen.

Ein Flottenmanagementsystem dient zum Verwalten, Planen, Steuern und Überwachen von Fahrzeugflotten, die auch als Fuhrpark bezeichnet wird. Dabei werden Wegstrecken von Fahrzeugen, unter Einbeziehung bestimmter Einflussparameter, aufeinander abgestimmt und festgelegt. Probleme sollen von einem Flottenmanagementsystem frühzeitig erkannt, behoben oder von vornherein umgangen werden.

Das Flottenmanagementsystem kann dabei eine Cloud-basierende Speichereinrichtung aufweisen, in dem Daten von den Fahrzeugen gespeichert werden. Zu den Daten von den Fahrzeugen gehören sowohl Daten von Lithium-ionen-Batterien, die in den Fahrzeugen eingesetzt werden, als auch Nutzungsprofile der Fahrzeuge und Fahrstile von Fahrern der Fahrzeuge.

### Vorteile der Erfindung

In den letzten Jahren wurde unter Hochdruck an präzisen Batteriemodellen geforscht, um interne Zustände, wie z.B. Ladezustand (SOC, engl.: State of Charge), Lithium-lonen-Konzentration und Anodenüberspannung, als auch externe Zustände, insbesondere Spannung, Strom und Betriebstemperatur, zu modellieren. Ziel einer präzisen Beschreibung eines Innenlebens der Batterie ist, Ladealgorithmen derart zu optimieren, dass die Batterie möglichst wenig altert bzw. möglichst lange lebt.

Bis heute kann nur vage argumentiert werden, wie ein Grenzwert für eine Anodenüberspannung festgelegt werden soll. Ein zu hoher Grenzwert würde das Laden zu konservativ auslegen und eine Ladezeit erhöhen. Ein zu niedriger Grenzwert führt zu aggressivem Laden und schnellem Altern der Batterie.

Mit dem erfindungsgemäßen Verfahren kann der Grenzwert der Anodenüberspannung der Lithium-lonen-Batterie online so aktualisiert werden, dass der Grenzwert immer am möglichen Optimum ist. Dadurch ist eine offline Kalibrierung nicht mehr benötigt.

Mit dem erfindungsgemäßen Verfahren kann ein robuster Ladealgorithmus entwickelt werden, der den Ladestrom so regelt, dass die Lithium-lonen-Batterie möglichst schonen behandelt wird, während Ladedauer und Energieinhalt optimiert werden.

Mit dem erfindungsgemäßen Verfahren kann entweder eine Ladedauer der Lithium-lonen-Batterie bei einer schonenden Alterung der Lithium-lonen-Batterie optimiert werden, oder eine schonende Alterung der Lithium-lonen-Batterie bei gleicher Ladedauer optimiert werden.

Darüber hinaus bildet das erfindungsgemäße Verfahren eine Grundlage für datenbasiertes Lernen und kann weiter entwickelt werden, wie beispielsweise für ein optimales Fahrverhalten und ein schonendes Alterungsverhalten im Fahr- und Parkbetrieb.

### Kurze Beschreibung der Zeichnungen

Ausführungsformen der Erfindung werden anhand der Zeichnungen und der nachfolgenden Beschreibung näher erläutert.

### Es zeigen:

- Figur 1: ein erstes Flussdiagramm des erfindungsgemäßen Verfahrens zum Anpassen einer Anodenüberspannung einer Lithium-lonen-Batterie,
- Figur 2: ein zweites Flussdiagramm des erfindungsgemäßen Verfahrens zum Verbessern eines Kapazitätsalterungszustands einer Lithium-lonen-Batterie und
- Figur 3: eine schematische Darstellung eines Fahrzeugs.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

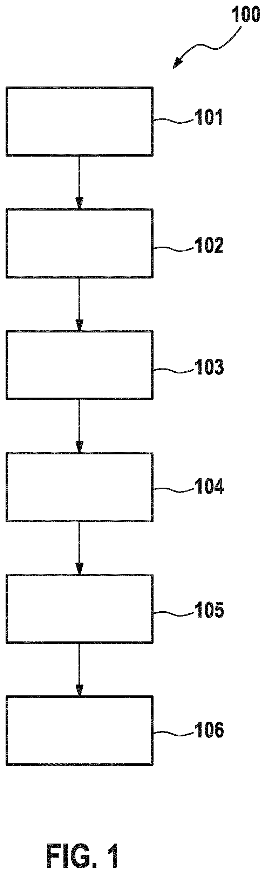

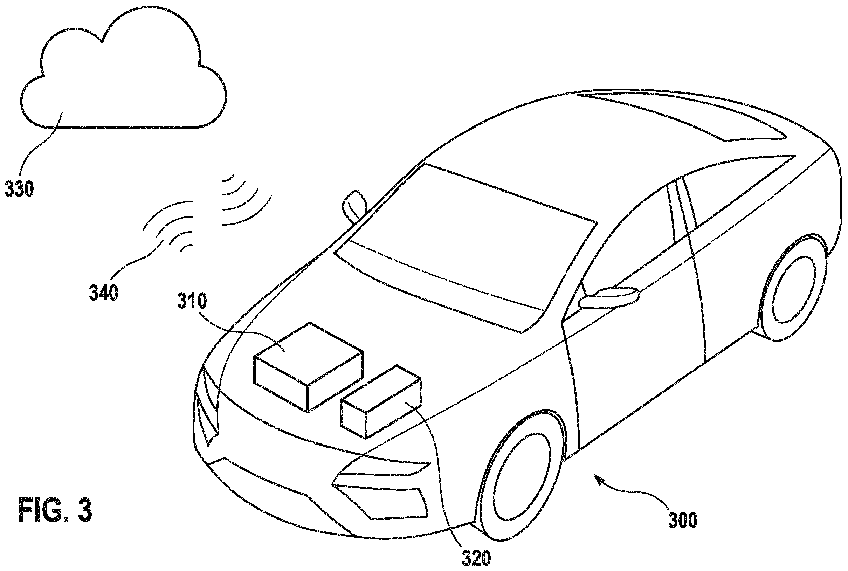

In Figur 1 ist ein erstes Flussdiagramm 100 des erfindungsgemäßen Verfahrens zum Anpassen einer Anodenüberspannung einer Lithium-lonen-Batterie 310 (siehe Figur 3) dargestellt.

In einem ersten Schritt 101 des ersten Flussdiagramms 100 werden Signalverläufe der Lithium-lonen-Batterie 310 bereitgestellt. Die Signalverläufe umfassen zumindest Spannungs-, Stroms- und Betriebstemperaturverläufe sowie eines Kapazitätsalterungszustandsverlaufs der Lithium-lonen-Batterie 310. Dabei wird ein Kapazitätsverlust der Lithium-lonen-Batterien 310 durch den Kapazitätsalterungszustandsverlauf dargestellt.

Anschließend werden die Signalverläufe und der Kapazitätsalterungszustandsverlauf der Lithium-lonen-Batterie 310 in einem zweiten Schritt 102 des ersten Flussdiagramms 100 zu einer Speichereinrichtung 330 (siehe Figur 3) übertragen. Dabei sind in der Speichereinrichtung 330 Daten von mehreren Lithium-lonen-Batterien 310 gespeichert, wobei die Daten zumindest Spannungs-, Stroms- und Betriebstemperaturverläufe sowie einen Kapazitätsalterungszustandsverlauf und einen Grenzwert der Anodenüberspannung der jeweiligen Lithium-Ionen-Batterie 310 umfassen.

In einem dritten Schritt 103 des ersten Flussdiagramms 100 werden die Signalverläufe der Lithium-lonen-Batterie 310 mit den in der Speichereinrichtung 330 gespeicherten Daten verglichen und Vergleichsbatterien, deren Signalverläufe ähnlich wie die Signalverläufe der Lithium-lonen-Batterie 310 werden ausgesucht.

In einem vierten Schritt 104 des ersten Flussdiagramms 100 werden die Daten der Vergleichsbatterien zum Erhalten eines durchschnittlichen Kapazitätsalterungszustandsverlaufs sowie eines durchschnittlichen Kapzitätsverlusts der Vergleichsbatterien untersucht. Dabei wird ebenfalls ein dem durchschnittlichen Kapazitätsverlust entsprechender optimierter Grenzwert der Anodenüberspannung erhalten.

In einem fünften Schritt 105 des ersten Flussdiagramms 100 wird der Kapazitätsalterungszustandsverlauf der Lithium-lonen-Batterie 310 mit dem durchschnittlichen Kapazitätsalterungszustandsverlauf der Vergleichsbatterien verglichen.

In einem sechsten Schritt 106 des ersten Flussdiagramms 100 wird der Grenzwert der Anodenüberspannung der Lithium-lonen-Batterie 310 an den optimierten Grenzwert der Anodenüberspannung angepasst, wenn erkannt wird, dass der Kapazitätsalterungszustandsverlauf der Lithium-lonen-Batterie 310 unter der durchschnittlichen Kapazitätsalterungszustandsverlauf der Vergleichsbatterien liegt. Mit dem an den optimierten Grenzwert angepassten Grenzwert der Anodenüberspannung der Lithium-lonen-Batterie 310 stimmt der Kapazitätsverlust der Lithium-lonen-Batterie mit dem durchschnittlichen Kapazitätsverlust überein.

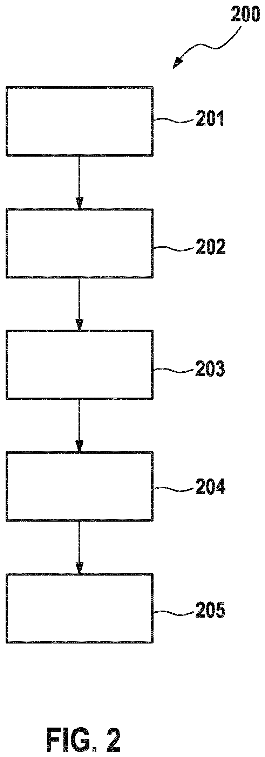

In Figur 2 ist ein zweites Flussdiagramm 200 des erfindungsgemäßen Verfahrens zum Verbessern eines Kapazitätsalterungszustands einer Lithium-lonen-Batterie 310 dargestellt.

In einem ersten Schritt 201 des zweiten Flussdiagramms 200 wird ein Kapazitätsalterungszustand der Lithium-lonen-Batterie 310 mittels eines Batteriemodells berechnet. Dabei wird ein Grenzwert einer Anodenüberspannung der Lithium-lonen-Batterie 310 abgeschätzt.

In einem zweiten Schritt 202 des zweiten Flussdiagramms 200 wird ein optimaler Ladestrom für die Lithium-lonen-Batterie 310 mittels eines Lademodells derart berechnet, dass die Anodenüberspannung der Lithium-lonen-Batterie 310 einen Grenzwert nicht unterschreitet, d.h. die Anodenüberspannung der Lithium-lonen-Batterie 310 soll größer als oder zumindest gleich dem Grenzwert sein.

In einem dritten Schritt 203 des zweiten Flussdiagramms 200 wird die Lithium-ionen-Batterie 310 mit dem optimalen Ladestrom geladen und überwacht. Dabei werden ein Kapazitätsalterungszustandsverlauf sowie Signalverläufe der Lithium-Ionen-Batterie erfasst, die zumindest Spannungs-, Stroms- und Betriebstemperaturverläufe umfassen.

In einem vierten Schritt 204 des zweiten Flussdiagramms 200 wird der Grenzwert der Anodenüberspannung der Lithium-lonen-Batterie 310 mittels des erfindungsgemäßen Verfahrens zum Anpassen eines Grenzwerts einer Anodenüberspannung einer Lithium-lonen-Batterien, das in Figur 1 beschrieben wird, angepasst.

In einem fünften Schritt 205 des zweiten Flussdiagramms 200 wird der optimale Ladestrom mittels des Lademodells mit dem angepassten Grenzwert der Lithium-ionen-Batterie 310 erneut berechnet.

Figur 3 zeigt schematisch ein Fahrzeug 300, das eine Lithium-lonen-Batterie 310 und ein Batteriemanagementsystem 320 aufweist.

Das Fahrzeug 300 umfasst ferner ein telematische Steuereinheit (nicht dargestellt), die bevorzugt im Batteriemanagementsystem 320 integriert wird, zur Datenübertragung zwischen dem Fahrzeugs 300 bzw. der Lithium-lonen-Batterie 310 und einer Speichereinrichtung 330 über eine Kommunikation 340.

Die Speichereinrichtung 330 ist dabei als ein Cloud-Speicher ausgebildet und dient zum Speichern von Daten mehrerer Lithium-lonen-Batterien 310.

Die Daten der Lithium-lonen-Batterie 310 des Fahrzeugs 300 werden durch das Batteriemanagementsystem 320 erfasst und zu der Speichereinrichtung 330 übertragen. Die Daten der Lithium-lonen-Batterie 310 werden danach mit den Daten, die in der Speichereinrichtung 330 gespeichert sind, verglichen, um Vergleichsbatterien auszusuchen.

Die Speichereinrichtung 330 ist dabei eingerichtet, das erfindungsgemäße Verfahren zum Anpassen einer Anodenüberspannung einer Lithium-lonen-Batterie 310 durchzuführen.

Sobald die Anodenüberspannung der Lithium-lonen-Batterie 310 angepasst wird, wird die angepasste Anodenüberspannung über die Kommunikation 340 zwischen dem Batteriemanagementsystem 320 und der Speichereinrichtung 330 an dem Batteriemanagementsystem 320 geschickt. Ein Lademodell (nicht dargestellt) des Batteriemanagementsystems 320 berechnet erneut einen optimalen Ladestrom anhand der angepassten Anodenüberspannung, damit ein Kapazitätsverlust der Lithium-lonen-Batterie 310 des Fahrzeugs 300 mit einem durchschnittlichen Kapazitätsverlust der Vergleichsbatterien übereinstimmt.

Das Fahrzeug 300 kann einer Fahrzeugflotte zugeordnet sein und die Speichereinrichtung 330 kann einem Flottenmanagementsystem zum Verwalten, Planen, Steuern und Überwachen aller Fahrzeuge der Fahrzeugflotte zugeordnet sein.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Verfahren zum Anpassen eines Grenzwerts einer Anodenüberspannung einer Lithium-lonen-Batterie (310), umfassend folgende Schritte:
- Bereitstellen von Signalverläufen der Lithium-lonen-Batterie (310), die zumindest Spannungs-, Stroms- und Betriebstemperaturverläufe sowie eines Kapazitätsalterungszustandsverlaufs der Lithium-lonen-Batterie (310) umfassen;
- Übertragen der Signalverläufe und des Kapazitätsalterungszustandsverlaufs der Lithium-lonen-Batterie (310) zu einer Speichereinrichtung (330), in dem Daten von mehreren Lithium-ionen-Batterien (310) gespeichert sind, die zumindest Spannungs-, Stroms- und Betriebstemperaturverläufe sowie einen Kapazitätsalterungszustandsverlauf und einen Grenzwert der Anodenüberspannung der jeweiligen Lithium-ionen-Batterien (310) umfassen;
- Vergleich der Signalverläufe der Lithium-lonen-Batterie (310) mit den in der Speichereinrichtung (330) gespeicherten Daten und Aussuchen von Vergleichsbatterien;
- Untersuchen der Daten der Vergleichsbatterien zum Erhalten eines durchschnittlichen Kapazitätsalterungszustandsverlaufs und eines durchschnittlichen Kapazitätsverlusts der Vergleichsbatterien sowie eines dem durchschnittlichen Kapazitätsverlust entsprechenden optimierten Grenzwerts der Anodenüberspannung;
- Vergleich des Kapazitätsalterungszustandsverlaufs der Lithium-lonen-Batterie (310) mit dem durchschnittlichen Kapazitätsalterungszustandsverlauf der Vergleichsbatterien;
- Anpassen des Grenzwerts der Anodenüberspannung der Lithium-ionen-Batterie (310) an den optimierten Grenzwert der Anodenüberspannung, wenn erkannt wird, dass der Kapazitätsalterungszustandsverlauf der Lithium-lonen-Batterie (310) unter der durchschnittlichen Kapazitätsalterungszustandsverlauf der Vergleichsbatterien liegt.

2. Verfahren nach Anspruch 1, **dadurch gekennzeichnet, dass** die Signalverläufe und der Kapazitätsalterungszustandsverlauf der Lithium-lonen-Batterie (310) mittels eines drahtlosen Netzwerks zu der Speichereinrichtung (330) übertragen werden.

3. Verfahren nach Anspruch 2, **dadurch gekennzeichnet, dass** das drahtlose Netzwerk als ein Mobilfunknetz ausgebildet wird.

4. Verfahren nach einem der Ansprüche 1 bis 3, **dadurch gekennzeichnet, dass**
die Speichereinrichtung (330) als ein Cloud-Speicher ausgebildet wird.

5. Verfahren nach einem der Ansprüche 1 bis 4, **dadurch gekennzeichnet, dass**
die Speichereinrichtung (330) ein auf künstliche Intelligenz basiertes Modell zum Anpassen des Grenzwerts der Anodenüberspannung der Lithium-lonen-Batterie (310) aufweist.

6. Verfahren zum Verbessern eines Kapazitätsalterungszustands einer Lithium-lonen-Batterie (310), umfassend folgende Schritte:
- Berechnen eines Kapazitätsalterungszustands der Lithium-lonen-Batterie (310) und Abschätzung eines Grenzwerts einer Anodenüberspannung der Lithium-lonen-Batterie (310) mittels eines Batteriemodells;
- Berechnen eines optimalen Ladestroms mittels eines Lademodells derart, dass die Anodenüberspannung der Lithium-lonen-Batterie (310) größer als oder gleich dem Grenzwert der Anodenüberspannung ist;
- Laden der Lithium-lonen-Batterie (310) mit dem optimalen Ladestrom und Überwachen der Lithium-lonen-Batterie, wobei ein Kapazitätsalterungszustandsverlauf sowie Signalverläufe der Lithium-ionen-Batterie (310) erfasst wird, die zumindest Spannungs-, Stroms- und Betriebstemperaturverlauf umfassen;
- Anpassen des Grenzwerts der Anodenüberspannung der Lithium-ionen-Batterie (310) gemäß dem Verfahren nach einem der Ansprüche 1 bis 5;
- Berechnen des optimalen Ladestroms mittels des Lademodells mit dem angepassten Grenzwert der Anodenüberspannung der Lithium-ionen-Batterie (310).

7. Verfahren nach Anspruch 6, **dadurch gekennzeichnet, dass** die Lithium-lonen-Batterie (310) mit einem Batteriemanagementsystem (320) zum Überwachen und Steuern der Lithium-lonen-Batterie (310) sowie zum Erfassen des Kapazitätsalterungszustandsverlaufs und der Signalverläufe der Lithium-lonen-Batterie (310) versehen wird, in dem das Batteriemodell und/oder das Lademodell integriert wird.

8. Verfahren nach Anspruch 6 oder 7, **dadurch gekennzeichnet, dass** der optimale Ladestrom basierend auf eine Optimalsteuerungstheorie berechnet wird.

9. Verfahren nach einem der Ansprüche 7 bis 8, **dadurch gekennzeichnet, dass**
das Batteriemanagementsystem (320) mit einer telematischen Steuereinheit zur Datenübertragung zwischen dem Batteriemanagementsystem (320) und der Speichereinrichtung (330) versehen wird.

10. Fahrzeug (300), umfassen mindestens eine Lithium-lonen-Batterie (310), und ein Batteriemanagementsystem (320), **dadurch gekennzeichnet, dass**
das Batteriemanagementsystem (320) so konfiguriert ist, dass eine Anodenüberspannung der mindestens einen Lithium-lonen-Batterie (310) gemäß dem Verfahren nach einem der Ansprüche 1 bis 5 angepasst ist und/oder ein Kapazitätsalterungszustand der mindestens einen Lithium-lonen-Batterie (310) gemäß dem Verfahren nach einem der Ansprüche 6 bis 9 verbessert ist.

11. Flottenmanagementsystem, das eingerichtet ist, das Verfahren nach einem der Ansprüche 1 bis 5 und/oder das Verfahren nach einem der Ansprüche 6 bis 9 durchzuführen.

## Claims

1. Method for adjusting a limit value for an anode overvoltage of a lithium-ion battery (310), comprising the following steps:
- providing signal characteristics of the lithium-ion battery (310) which comprise at least voltage, current and operating temperature characteristics and a capacity state of health characteristic of the lithium-ion battery (310);
- transmitting the signal characteristics and the capacity state of health characteristic of the lithium-ion battery (310) to a storage device (330), in which data relating to a plurality of lithium-ion batteries (310) are stored which comprise at least voltage, current and operating temperature characteristics and a capacity state of health characteristic and a limit value for the anode overvoltage of the respective lithium-ion batteries (310) ;
- comparing the signal characteristics of the lithium-ion battery (310) with the data stored in the storage device (330) and choosing comparison batteries;
- investigating the data relating to the comparison batteries in order to obtain an average capacity state of health characteristic and an average capacity loss of the comparison batteries and an optimized limit value, corresponding to the average capacity loss, for the anode overvoltage;
- comparing the capacity state of health characteristic of the lithium-ion battery (310) with the average capacity state of health characteristic of the comparison batteries;
- adjusting the limit value for the anode overvoltage of the lithium-ion battery (310) to the optimized limit value for the anode overvoltage when it is identified that the capacity state of health characteristic of the lithium-ion battery (310) is below the average capacity state of health characteristic of the comparison batteries.

2. Method according to Claim 1, **characterized in that** the signal characteristics and the capacity state of health characteristic of the lithium-ion battery (310) are transmitted to the storage device (330) by means of a wireless network.

3. Method according to Claim 2, **characterized in that** the wireless network is in the form of a mobile radio network.

4. Method according to one of Claims 1 to 3, **characterized in that**
the storage device (330) is in the form of cloud storage.

5. Method according to one of Claims 1 to 4, **characterized in that**
the storage device (330) has a model based on artificial intelligence for adjusting the limit value for the anode overvoltage of the lithium-ion battery (310).

6. Method for improving a capacity state of health of a lithium-ion battery (310), comprising the following steps:
- calculating a capacity state of health of the lithium-ion battery (310) and estimating a limit value for an anode overvoltage of the lithium-ion battery (310) by means of a battery model;
- calculating an optimum charging current by means of a charging model in such a way that the anode overvoltage of the lithium-ion battery (310) is greater than or equal to the limit value for the anode overvoltage;
- charging the lithium-ion battery (310) with the optimum charging current and monitoring the lithium-ion battery, wherein a capacity state of health characteristic and signal characteristics of the lithium-ion battery (310), which comprise at least voltage, current and operating temperature characteristics, are detected;
- adjusting the limit value for the anode overvoltage of the lithium-ion battery (310) in accordance with the method according to one of Claims 1 to 5;
- calculating the optimum charging current by means of the charging model using the adjusted limit value for the anode overvoltage of the lithium-ion battery (310).

7. Method according to Claim 6, **characterized in that** the lithium-ion battery (310) is provided with a battery management system (320) for monitoring and controlling the lithium-ion battery (310) and for detecting the capacity state of health characteristic and the signal characteristics of the lithium-ion battery (310), in which battery management system the battery model and/or the charging model is/are integrated.

8. Method according to Claim 6 or 7, **characterized in that**
the optimum charging current is calculated on the basis of an optimal control theory.

9. Method according to one of Claims 7 to 8, **characterized in that**
the battery management system (320) is provided with a telematic control unit for data transmission between the battery management system (320) and the storage device (330) .

10. Vehicle (300), comprising at least one lithium-ion battery (310) and a battery management system (320), **characterized in that**
the battery management system (320) is configured in such a way that an anode overvoltage of the at least one lithium-ion battery (310) has been adjusted in accordance with the method according to one of Claims 1 to 5 and/or a capacity state of health of the at least one lithium-ion battery (310) has been improved in accordance with the method according to one of Claims 6 to 9.

11. Fleet management system, which is designed to perform the method according to one of Claims 1 to 5 and/or the method according to one of Claims 6 to 9.

## Revendications

1. Procédé permettant d'adapter une valeur limite d'une surtension anodique d'une batterie lithium-ion (310), comprenant les étapes suivantes consistant à :
- fournir des courbes de signal de la batterie lithium-ion (310) qui comprennent au moins des courbes de tension, de courant et de température de service ainsi qu'une courbe d'état de vieillissement de capacité de la batterie lithium-ion (310) ;
- transmettre les courbes de signal et la courbe d'état de vieillissement de capacité de la batterie lithium-ion (310) à un dispositif de mémoire (330) dans lequel sont stockées des données de plusieurs batteries lithium-ion (310) qui comprennent au moins des courbes de tension, de courant et de température de service ainsi qu'une courbe d'état de vieillissement de capacité et une valeur limite de la surtension anodique des batteries lithium-ion (310) respectives ;
- comparer les courbes de signal de la batterie lithium-ion (310) avec les données stockées dans le dispositif de mémoire (330), et sélectionner des batteries de comparaison ;
- examiner les données des batteries de comparaison pour obtenir une courbe d'état de vieillissement de capacité moyen et une perte de capacité moyenne des batteries de comparaison ainsi qu'une valeur limite optimisée de la surtension anodique correspondant à la perte de capacité moyenne ;
- comparer la courbe d'état de vieillissement de capacité de la batterie lithium-ion (310) avec la courbe d'état de vieillissement de capacité moyen des batteries de comparaison ;
- adapter la valeur limite de la surtension anodique de la batterie lithium-ion (310) à la valeur limite optimisée de la surtension anodique lorsqu'il est détecté que la courbe d'état de vieillissement de capacité de la batterie lithium-ion (310) est située sous la courbe d'état de vieillissement de capacité moyen des batteries de comparaison.

2. Procédé selon la revendication 1, **caractérisé en ce que** les courbes de signal et la courbe d'état de vieillissement de capacité de la batterie lithium-ion (310) sont transmises au dispositif de mémoire (330) au moyen d'un réseau sans fil.

3. Procédé selon la revendication 2, **caractérisé en ce que** le réseau sans fil est réalisé sous la forme d'un réseau de téléphonie mobile.

4. Procédé selon l'une quelconque des revendications 1 à 3, **caractérisé en ce que** le dispositif de mémoire (330) est réalisé sous la forme d'un stockage en nuage.

5. Procédé selon l'une quelconque des revendications 1 à 4, **caractérisé en ce que** le dispositif de mémoire (330) présente un modèle basé sur l'intelligence artificielle pour adapter la valeur limite de la surtension anodique de la batterie lithium-ion (310).

6. Procédé permettant d'améliorer un état de vieillissement de capacité d'une batterie lithium-ion (310), comprenant les étapes suivantes consistant à :
- calculer un état de vieillissement de capacité de la batterie lithium-ion (310), et estimer une valeur limite d'une surtension anodique de la batterie lithium-ion (310) au moyen d'un modèle de batterie ;
- calculer un courant de charge optimal au moyen d'un modèle de charge de telle sorte que la surtension anodique de la batterie lithium-ion (310) est supérieure ou égale à la valeur limite de la surtension anodique ;
- charger la batterie lithium-ion (310) avec le courant de charge optimal, et surveiller la batterie lithium-ion, dans lequel une courbe d'état de vieillissement de capacité ainsi que des courbes de signal de la batterie lithium-ion (310) qui comprennent au moins une courbe de tension, une courbe de courant et une courbe de température de service sont détectées ;
- adapter la valeur limite de la surtension anodique de la batterie lithium-ion (310) selon le procédé selon l'une quelconque des revendications 1 à 5 ;
- calculer le courant de charge optimal au moyen du modèle de charge avec la valeur limite adaptée de la surtension anodique de la batterie lithium-ion (310).

7. Procédé selon la revendication 6, **caractérisé en ce que** la batterie lithium-ion (310) est équipée d'un système de gestion de batterie (320) pour surveiller et commander la batterie lithium-ion (310) ainsi que pour détecter la courbe d'état de vieillissement de capacité et les courbes de signal de la batterie lithium-ion (310) dans lequel le modèle de batterie et/ou le modèle de charge est/sont intégré(s).

8. Procédé selon la revendication 6 ou 7, **caractérisé en ce que** le courant de charge optimal est calculé sur la base d'une théorie de commande optimale.

9. Procédé selon l'une quelconque des revendications 7 à 8, **caractérisé en ce que** le système de gestion de batterie (320) est équipé d'une unité de commande télématique pour la transmission de données entre le système de gestion de batterie (320) et le dispositif de mémoire (330).

10. Véhicule (300), comprenant au moins une batterie lithium-ion (310) et un système de gestion de batterie (320), **caractérisé en ce que** le système de gestion de batterie (320) est configuré de telle sorte qu'une surtension anodique de ladite au moins une batterie lithium-ion (310) est adaptée selon le procédé selon l'une quelconque des revendications 1 à 5, et/ou un état de vieillissement de capacité de ladite au moins une batterie lithium-ion (310) est amélioré selon le procédé selon l'une quelconque des revendications 6 à 9.

11. Système de gestion de flotte qui est conçu pour exécuter le procédé selon l'une quelconque des revendications 1 à 5 et/ou le procédé selon l'une quelconque des revendications 6 à 9.
